# EUROPEAN PATENT SPECIFICATION

(11) **EP 0 317 152 B1**
(45) Date of publication and mention of the grant of the patent: **14.09.1994**
(21) Application number: 88310490.3
(22) Date of filing: 08.11.1988
(51) Int. Cl.: H01L 29/92, H01L 27/10, H01L 21/82

(54) **Trench capacitor and method for producing the same**
Grabenkapazität und Verfahren zu ihrer Herstellung
Capacité en forme de tranchées et procédé de fabrication

(30) Priority: 13.11.1987 JP 285440/87
(43) Date of publication of application: 24.05.1989
(73) Proprietor: FUJITSU LIMITED, Kawasaki-shi, Kanagawa 211 (JP)
(72) Inventor: Matsutani, Takeshi, Machida-shi Tokyo 194-01 (JP); Imaoka, Kazunori, Komae-shi Tokyo 201 (JP)
(74) Representative: Billington, Lawrence Emlyn

(56) References cited:
- EP-A- 0 150 597
- EP-A- 0 197 762
- PATENT ABSTRACTS OF JAPAN vol. 13, no. 74 (E-717)(3422) 20 February 1989 ; & JP-A-63 257 263
- PATENT ABSTRACTS OF JAPAN vol. 10, no. 24 (E-377)(2081) 30 January 1986 ; & JP-A-60 183 765
- PATENT ABSTRACTS OF JAPAN vol. 11, no. 212 (E-522)(2659) 09 July 1987 ; & JP-A-62 33450

## Description

The present invention relates to a semiconductor device and a method for producing same. More particularly, it relates to a semiconductor device having a memory structure suitable for a high degree of integration and a method for producing same.

Recently, in a semiconductor device having a memory structure with a capacitor, for example, a Dynamic Random Access Memory (DRAM), various structures have been proposed by which the degree of integration can be increased.

An increase of a degree of integration of a planar type DRAM has been limited, and thus, to increase the degree of integration, a tertiary structure has been developed.

A stacked type or trench type structure are well known tertiary structures but an increase of the degree of integration of the stacked type capacitor is also limited, and therefore, the trench type capacitor is widely used at present as a DRAM capacitor.

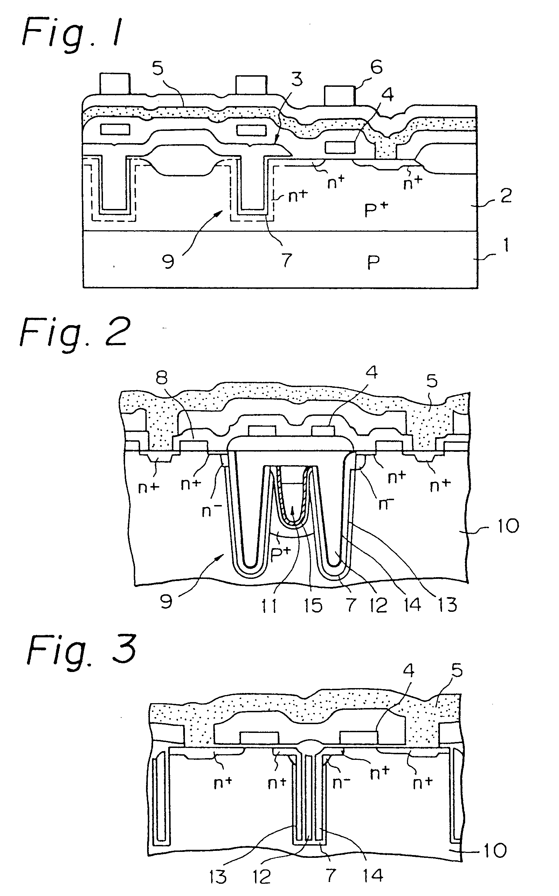

Figure 1 shows a previous proposal in which trench type capacitors are provided with a LOCOS type isolation therebetween.

In Fig. 1, a p⁺ silicon layer 2, n⁺ silicon region, n⁺ silicon source-drain regions and a trench capacitor 9 are formed on a p type substrate 1. The trench capacitor is formed by the n⁺ silicon layer, an SiO₂ layer 7 and a first polycrystalline silicon layer 3. Further, a second polycrystalline silicon layer 5 acts as a bit line, an aluminum layer 6 and a polycide layer 4 act as word lines.

In the DRAM shown in Fig. 1, when the size of the DRAM is miniaturized, to increase the degree of integration, the element isolation effect is reduced and a leak is generated between the trench capacitors 9, and the source and drain regions (n⁻ silicon regions).

Figure 2 shows another prior proposal, which is an improvement of the device structure shown in Fig. 1.

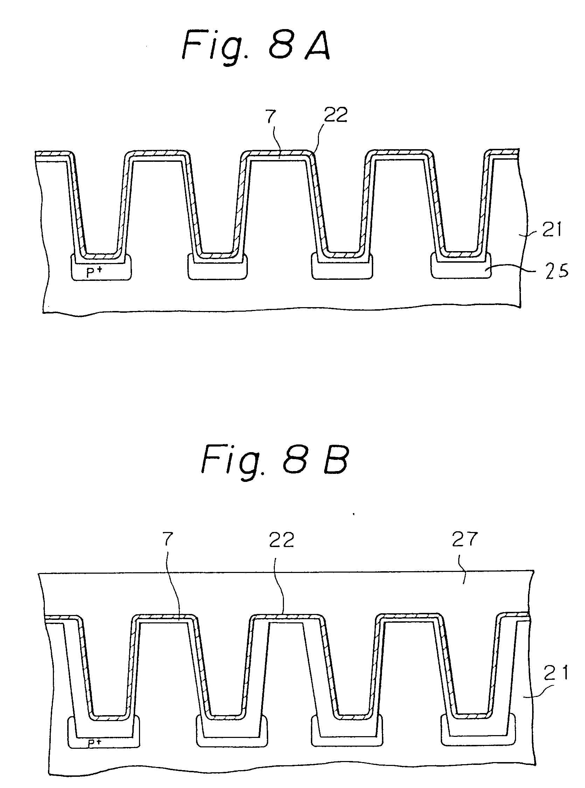

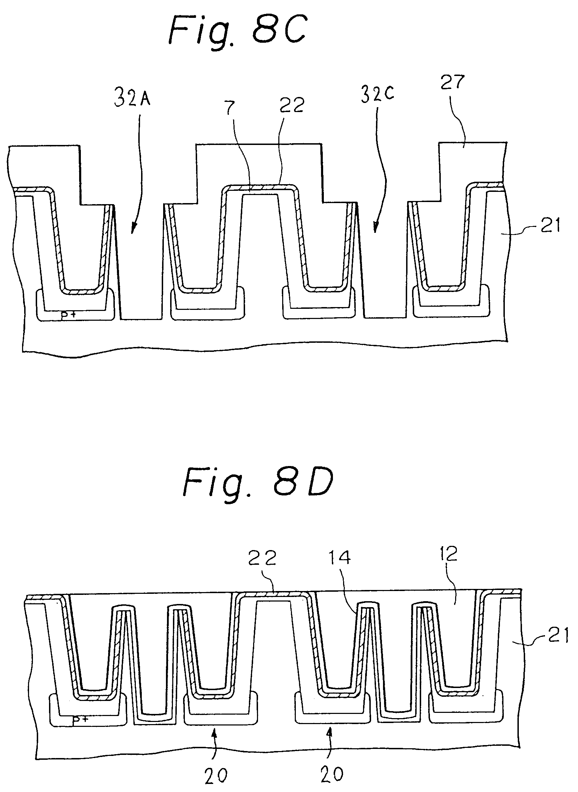

In Fig. 2, to prevent the leakage between the trench capacitors, isolation between the trench capacitors 9 is also provided by forming a trench. In the structure of Fig. 2, the leakage between the trench capacitors is prevented, but to increase the degree of integration, the depth of the trench capacitor must be increased, and processing for increasing the depth of the trench capacitor is very difficult. In Fig. 2, 8 is a transfer gate, 10 is a silicon substrate, 11 is a isolation trench, 12 is a polycrystalline silicon layer (cell plate), 13 is a polycrystalline silicon layer, 14 is a capacitor insulating layer of, for example, SiO₂ and 15 is a silicon nitride layer.

Figure 3 shows a proposed isolation merged vertical capacitor (IVEC) cell type structure in which a capacitor is formed at both sides of an isolation trench, and a cell plate is formed in the same trench.

Nevertheless, if this structure is further miniaturized, the capacitance becomes small, and thus the depth of the trench must be increased to increase the capacitance, and as explained above, the process for increasing the depth of the trench is difficult.

The reference numbers used in Fig. 3, which are the same as those used in Figs. 1 and 2, denote the same elements.

This holds true throughout the remaining Figures.

EP-A-0 150 597 by Toshiba K. K. discloses a semiconductor memory device having a trench capacitor and manufacturing method therefor, in which an insulating film is buried in a first groove, and the first groove is used as a mask for forming adjacent second grooves for memory capacitors. A capacitor electrode is formed in the second grooves and over the first groove in common.

According to a first aspect of the present invention there is provided a semiconductor memory device provided with first and second trench capacitors in neighbouring cells and an isolation trench formed between the trench capacitors, each of which capacitors comprises a capacitor trench formed in a semiconductor substrate, an insulating layer covering side walls and bottom of the capacitor trench, a storage node formed on the insulating layer, a capacitor insulating layer, and a cell plate filling the capacitor trench, characterized in that an additional capacitor portion joining each of said trench capacitors is formed in said isolation trench; the additional capacitor portion comprising an additional storage node which comes into contact with said storage node and is formed on another insulating layer at that side of said isolation trench which is adjacent to the corresponding capacitor trench, the capacitor insulating layer covering said additional storage node, and the cell plate filling said isolation trench.

According to a second aspect of the present invention there is provided a method of producing a semiconductor memory device provided with first and second trench capacitors in neighbouring cells and an isolation trench between the trench capacitors comprising the steps of:-
forming said isolation trench in a semiconductor substrate;
forming an insulating layer in said isolation trench;
forming a mask layer;
selectively etching said substrate by using said mask layer to form capacitor trenches for said trench capacitors;
forming another insulating layer in said capacitor trenches;
forming a polycrystalline silicon layer to cover the entire surface;
selectively etching said polycrystalline silicon layer to form a storage node in each of said capacitor trenches and an additional storage node which comes into contact with said storage node and is formed on said insulating layer at that side of said isolation trench which is adjacent to the corresponding capacitor trench;
forming a capacitor insulating layer on the storage node and additional storage node; and
forming a cell plate on said capacitor insulating layer to fill the capacitor trenches and the isolation trench.

An embodiment of the invention may provide a semiconductor device and a method for producing the same in which the above-mentioned leakage between trench capacitors and between transistors can be prevented.

An embodiment of the present invention may provide a semiconductor device which is suitable for use in a miniaturized device, and a method for producing the same.

Reference is made, by way of example, to the accompanying drawings, in which:-
Fig. 1 shows a prior proposal in which trench-type capacitors are provided with a LOCOS-type isolation therebetween;
Fig. 2 shows another prior proposal as an improvement of the device shown in Fig. 1;
Fig. 3 shows a proposed isolation merged vertical capacitor (IVEC) cell-type structure in which a capacitor is formed at both sides of an isolation trench and a cell plate is formed in the isolation trench;
Fig. 4 is a plan view of an example of the present invention;
Figs. 5 and 6 are an AB cross-sectional view and an XY cross-sectional view of Fig. 4, respectively;
Figs. 7A to 7D are step cross-sectional views taken along line AB of Fig. 4, and
Figs. 8A to 8D are step cross-sectional views taken along line XY of Fig. 4.

The preferred embodiment of the present invention will be described with reference to the drawings.

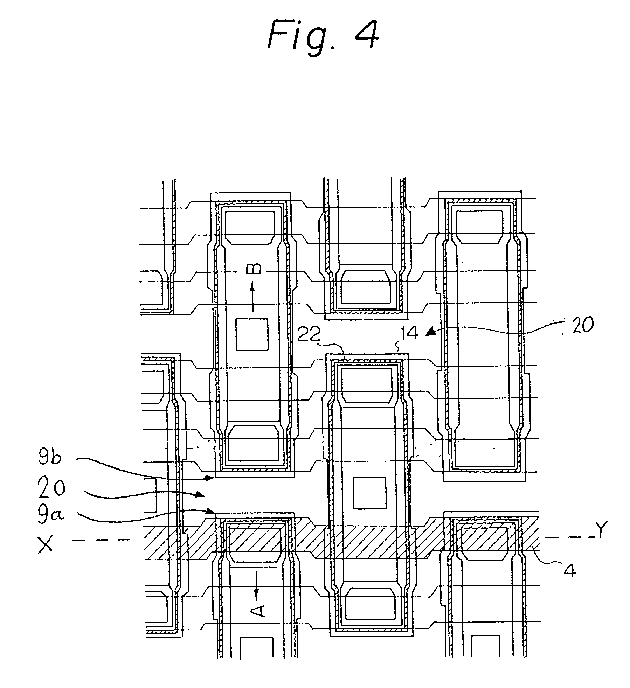

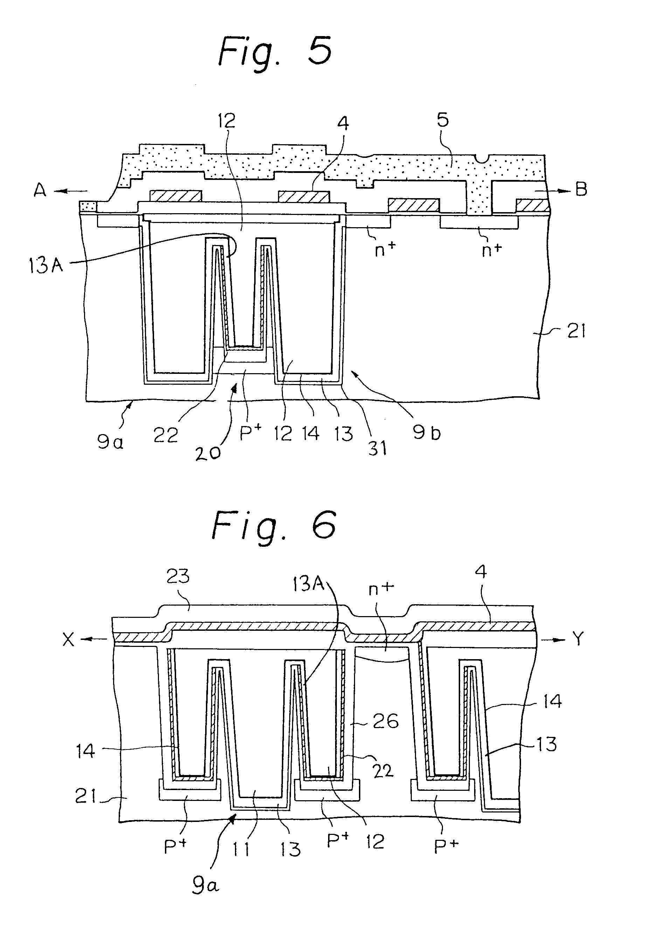

Fig. 4 is a plan view of an example of the present invention, and Figs. 5 and 6 are an AB cross-sectional view and an XY cross-sectional view of Fig. 4, respectively.

The structure of first and second trench capacitors 9a and 9b consists of an SiO₂ layer 31, a storage node 13, a capacitor insulating nitride layer 14, and a cell plate 12.

The cell plate 12 of polycrystalline silicon is formed on the capacitor insulating layer 14.

As shown in Fig. 5, an isolation trench 20 is formed between the first and second trench capacitors 9a and 9b. The isolation trench has a depth of 3 µm. Further, in the isolation trench 20, an additional storage node 13A of polycrystalline silicon is formed between a nitride layer 22 and the capacitor insulating layer 14.

The additional storage node 13A is connected on one sidewall of the isolation trench to the first trench capacitor, and on the other sidewall of the isolation trench to the second trench capacitor.

Therefore, in the present invention, the isolation trench 20 provides an isolation zone between the trench capacitors 9a and 9b and functions as an additional trench capacitor.

Since, in this example, another isolation trench and additional capacitor are formed between the trench capacitors, not only can isolation be provided between the trench capacitors but also an increase of the capacitance thereof can be realized.

A method for providing the semiconductor device according to the present invention will now be explained with reference to Figs. 7A to 7D and Figs. 8A to 8D.

Figs. 7A to 7D are step cross-sectional views taken along line AB of Fig. 4, and Figs. 8A to 8D are step cross-sectional views taken along line XY of Fig. 4.

First, as shown in Figs. 7A and 8A, after forming isolation trenches in a silicon substrate 21 by an etching process, an impurity doped region, for example, a p⁺-type region 25, for a channel stop is formed at the bottom of the trench, the silicon substrate 21 is thermally oxidized to form an SiO₂ layer 7, and an Si₃N₄ layer 22 for the LOCOS process of the side wall is formed on the SiO₂ layer 7.

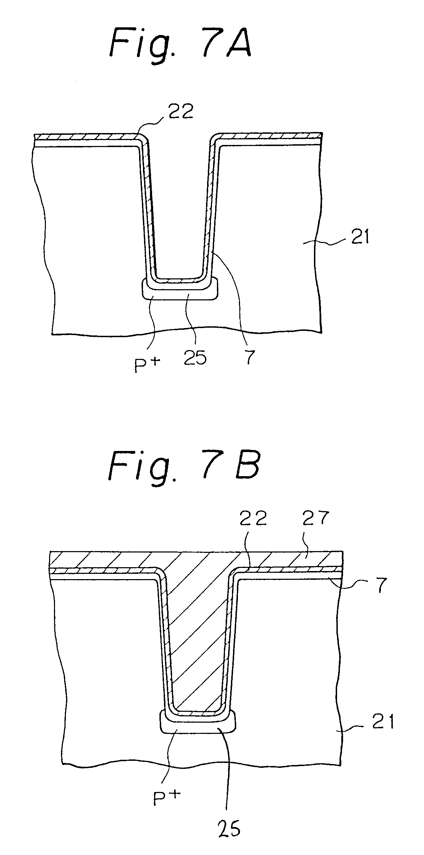

Then, as shown in Figs. 7B and 8B, an insulating layer 26 is formed and a phosphosilicate glass (PSG) 27 is embedded in the trench. The PSG 27 is used as a mask for etching the trench to produce a capacitor.

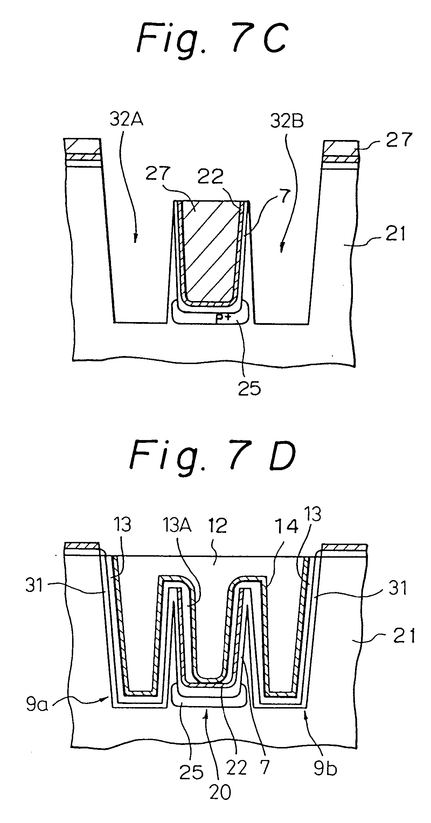

As shown in Figs. 7C and 8C, the Si substrate is etched using the PSG 27 as a mask, by a self-alignment process, to form capacitor trenches 32A, 32B and 32C.

Subsequently, as shown in Figs. 7D and 8D, the PSG 27 on the surface and in the trench is removed, and an insulating layer 31 is formed. Then, an electron charge accumulated layer for the storage nodes 13 and 13A is formed, electrode portions adjacent to the capacitors are separated by a conventional lithography process, a capacitor insulating layer 22 of Si₃N₄ is formed by a CVD process, and then a polycrystalline silicon layer is formed on the entire surface by a CVD process, to fill the trench with the polycrystalline silicon. The polycrystalline portions on the Si₃N₄ layer 22 are then removed by etching, so that the polycrystalline silicon is left only in the trench, whereby a cell plate 12 is formed.

Then, a transfer transistor is formed by a usual MOS FET production process, whereby a memory device provided with a trench isolation region possessing a capacitor function is obtained.

## Claims

1. A semiconductor memory device provided with first and second trench capacitors (9a, 9b) in neighbouring cells and an isolation trench (20) formed between the trench capacitors, each of which capacitors comprises a capacitor trench (32A, 32B, 32C) formed in a semiconductor substrate (21), an insulating layer (31) covering side walls and bottom of the capacitor trench, a storage node (13) formed on the insulating layer (31), a capacitor insulating layer (14), and a cell plate (12) filling the capacitor trench, characterized in that an additional capacitor portion joining each of said trench capacitors is formed in said isolation trench (20); the additional capacitor portion comprising an additional storage node (13A) which comes into contact with said storage node (13) and is formed on another insulating layer (7, 22) at that side of said isolation trench (20) which is adjacent to the corresponding capacitor trench (32A, 32B, 32C), the capacitor insulating layer (14) covering said additional storage node (13A), and the cell plate (12) filling said isolation trench (20).

2. A semiconductor memory device according to claim 1, wherein said semiconductor substrate (21) is made of silicon.

3. A method of producing a semiconductor memory device provided with first and second trench capacitors (9a, 9b) in neighbouring cells and an isolation trench (20) between the trench capacitors comprising the steps of:-
forming said isolation trench (20) in a semiconductor substrate (21);
forming an insulating layer (7, 22) in said isolation trench (20);
forming a mask layer (27);
selectively etching said substrate (21) by using said mask layer (27) to form capacitor trenches (32A, 32B, 32C) for said trench capacitors;
forming another insulating layer (31) in said capacitor trenches;
forming a polycrystalline silicon layer to cover the entire surface;
selectively etching said polycrystalline silicon layer to form a storage node (13) in each of said capacitor trenches (32A, 32B, 32C) and an additional storage node (13A) which comes into contact with said storage node (13) and is formed on said insulating layer (22) at that side of said isolation trench (20) which is adjacent to the corresponding capacitor trench (32A, 32B, 32C);
forming a capacitor insulating layer (14) on the storage node (13) and additional storage node (13A); and
forming a cell plate (12) on said capacitor insulating layer (14) to fill the capacitor trenches (32A, 32B, 32C) and the isolation trench (20).

4. A method according to claim 3, wherein said mask layer is a phosphosilicate glass layer.

## Patentansprüche

1. Eine Halbleiterspeicheranordnung, die mit ersten und zweiten Grabenkondensatoren (9a, 9b) in benachbarten Zellen und einem Isolationsgraben (20), der zwischen den Grabenkondensatoren gebildet ist, versehen ist, bei der jeder der genannten Kondensatoren einen Kondensatorgraben (32A, 32B, 32C) umfaßt, der in einem Halbleitersubstrat (21) gebildet ist, eine Isolierschicht (31), die Seitenwände und Boden des Kondensatorgrabens bedeckt, einen Speicherknoten (13), der auf der Isolierschicht (31) gebildet ist, eine Kondensatorisolierschicht (14) und eine Zellenplatte (12), die den Kondensatorgraben füllt, dadurch gekennzeichnet, daß ein zusätzlicher Kondensatorabschnitt, der sich an jeden der genannten Grabenkondensatoren anschließt, in dem genannten Isolationsgraben (20) gebildet ist; welcher zusätzliche Kondensatorabschnitt einen zusätzlichen Speicherknoten (13A) umfaßt, der mit dem genannten Speicherknoten (13) in Kontakt gelangt und auf einer anderen Isolierschicht (7, 22) an jener Seite des genannten Isolationsgrabens (20) gebildet ist, die an den entsprechenden Kondensatorgraben (32A, 32B, 32C) angrenzt, welche Kondensatorisolierschicht (14) den genannten zusätzlichen Speicherknoten (13A) bedeckt und welche Zellenplatte (12) den genannten Isolationsgraben (20) füllt.

2. Eine Halbleiterspeicheranordnung nach Anspruch 1, bei der das genannte Halbleitersubstrat (21) aus Silizium hergestellt ist.

3. Ein Verfahren zum Herstellen einer Halbleiterspeicheranordnung, die mit ersten und zweiten Grabenkondensatoren (9a, 9b) in benachbarten Zellen und einem Isolationsgraben (20) zwischen den Grabenkondensatoren versehen ist, mit den Schritten:-
Bilden des genannten Isolationsgrabens (20) in einem Halbleitersubstrat (21);
Bilden einer Isolierschicht (7, 22) in dem genannten Isolationsgraben (20);
Bilden einer Maskenschicht (27);
selektives Ätzen des genannten Substrats (21) unter Verwendung der genannten Maskenschicht (27), um Kondensatorgräben (32A, 32B, 32C) für die genannten Grabenkondensatoren zu bilden;
Bilden einer anderen Isolierschicht (31) in den genannten Kondensatorgräben;
Bilden einer polykristallinen Siliziumschicht, um die gesamte Oberfläche zu bedecken;
selektives Ätzen der genannten polykristallinen Siliziumschicht, um einen Speicherknoten (13) in jedem der genannten Kondensatorgräben (32A, 32B, 32C) und einen zusätzlichen Speicherknoten (13A) zu bilden, der mit dem genannten Speicherknoten (13) in Kontakt gelangt und auf der genannten Isolierschicht (22) an jener Seite des genannten Isolationsgrabens (20) gebildet ist, die an den entsprechenden Kondensatorgraben (32A, 32B, 32C) angrenzt;
Bilden einer Kondensatorisolierschicht (14) auf dem Speicherknoten (13) und zusätzlichen Speicherknoten (13A); und
Bilden einer Zellenplatte (12) auf der genannten Kondensatorisolierschicht (14), um die Kondensatorgräben (32A, 32B, 32C) und den Isolationsgraben (20) zu füllen.

4. Ein Verfahren nach Anspruch 3, bei dem die genannte Maskenschicht eine Phosphorsilicatglasschicht ist.

## Revendications

1. Dispositif de mémoire à semiconducteur muni de première et seconde capacités en tranchée (9a, 9b) contenues dans des cellules voisines et d'une tranchée d'isolation (20) formée entre les capacités en tranchée, chaque capacité comprenant une tranchée de capacité (32A, 32B, 32C) formée dans un substrat semiconducteur (21), une couche isolante (31) recouvrant des parois latérales et le fond de la tranchée de capacité, un noeud de stockage (13) formé sur la couche isolante (31), une couche d'isolation de capacité (14) et une plaque de cellule (12) remplissant la tranchée de capacité, caractérisé en ce qu'une partie de capacité supplémentaire joignant chacune desdites capacités en tranchée est formée dans ladite tranchée d'isolation (20) ; la partie de capacité supplémentaire comprenant un noeud de stockage supplémentaire (13A) qui vient en contact avec ledit noeud de stockage (13) et qui est formé sur une autre couche isolante (7, 22) au niveau du côté de ladite tranchée d'isolation (20) qui est adjacent à la tranchée de capacité correspondante (32A, 32B, 32C), la couche d'isolation de capacité (14) recouvrant ledit noeud de stockage supplémentaire (13A), et la plaque de cellule (12) remplissant ladite tranchée d'isolation (20).

2. Dispositif de mémoire à semiconducteur selon la revendication 1, dans lequel ledit substrat semiconducteur (21) est réalisé en silicium.

3. Procédé de fabrication d'un dispositif de mémoire à semiconducteur muni de première et seconde capacités en tranchée (9a, 9b) contenues dans des cellules voisines et d'une tranchée d'isolation (20) située entre les capacités en tranchée, comprenant les étapes de :
formation de ladite tranchée d'isolation (20) dans un substrat semiconducteur (21) ;
formation d'une couche isolante (7, 22) dans ladite tranchée d'isolation (20) ;
formation d'une couche de masquage (27) gravure sélective dudit substrat (21) en utilisant ladite couche de masquage (27) pour former des tranchées de capacité (32A, 32B, 32C) pour lesdites capacités en tranchée ;
formation d'une autre couche isolante (31) dans lesdites tranchées de capacité ;
formation d'une couche en silicium polycristallin pour recouvrir la totalité de la surface ;
gravure sélective de ladite couche en silicium polycristallin pour former un noeud de stockage (13) dans chacune desdites tranchées de capacité (32A, 32B, 32C) et un noeud de stockage supplémentaire (13A) qui vient en contact avec ledit noeud de stockage (13) et qui est formé sur ladite couche isolante (22) au niveau du côté de ladite tranchée d'isolation (20) qui est adjacent à la tranchée de capacité correspondante (32A, 32B, 32C) ;
formation d'une couche d'isolation de capacité (14) sur le noeud de stockage (13) et sur le noeud de stockage supplémentaire (13A) ; et
formation d'une plaque de cellule (12) sur ladite couche d'isolation de capacité (14) de manière à remplir les tranchées de capacité (32A, 32B, 32C) et la tranchée d'isolation (20).

4. Procédé selon la revendication 3, dans lequel ladite couche de masquage est une couche de verre de phosphosilicate.
